Europäisches Patentamt

European Patent Office

Office européen des brevets

(11) Veröffentlichungsnummer: **0 287 071 B1**

# EUROPÄISCHE PATENTSCHRIFT

(45) Veröffentlichungstag der Patentschrift: **11.12.91**

(51) Int. Cl.⁵: **B23Q 3/157**, H05K 3/00, H05K 13/00, B23B 39/04

(21) Anmeldenummer: **88105890.3**

(22) Anmeldetag: **13.04.88**

(54) Werkzeugwechselanordnung für Leiterplatten-Koordinatenbohr-maschinen.

(30) Priorität: **16.04.87 DE 3713046**

(43) Veröffentlichungstag der Anmeldung:
**19.10.88 Patentblatt 88/42**

(45) Bekanntmachung des Hinweises auf die Patenterteilung:
**11.12.91 Patentblatt 91/50**

(84) Benannte Vertragsstaaten:
**CH DE FR GB IT LI**

(56) Entgegenhaltungen:
**EP-A- 0 120 588**
**DE-A- 2 844 088**
**US-A- 4 088 417**

(73) Patentinhaber: **KLG KAUFBEURER LEITER-PLATTEN GMBH**
**Ingenrieder Strasse 4**
**W-8950 Kaufbeuren(DE)**

(72) Erfinder: **Petrick, Gerhard**
**Gladiolenweg 3**
**W-8951 Mauerstetten(DE)**

(74) Vertreter: **Ruschke, Hans Edvard, Dipl.-Ing. et al**
**Patentanwälte Ruschke & Partner Pienzenauerstrasse 2**
**W-8000 München 80(DE)**

## Beschreibung

Die vorliegende Erfindung betrifft eine Werkzeugwechselanordnung für Leiterplatten-Koordinatenbohrmaschinen nach dem Oberbegriff des Patentanspruches 1.

Bei der Herstellung von elektronischen Baugruppen für alle möglichen Anwendungsfälle werden sehr häufig gedruckte Schaltungen auf Leiterplatten verwendet, wobei aktive elektronische Komponenten in entsprechend angeordnete Bohrungen dieser Leiterplatte/gedruckten Schaltung eingesetzt und dort verlötet werden. Hierfür müssen also die Leiterplatten im Zuge ihrer oft in sehr hohen Stückzahlen erfolgenden Herstellung mit diesen Bohrungen versehen werden, die je nach Art der Leiterplatte in verschiedenen Durchmessern und/oder Tiefen (z.B. bei Mehrlagenplatten) und in Stückzahlen von bis zu einigen 1000 pro Leiterplatte benötigt werden. Es liegt auf der Hand, daß eine wirtschaftliche Fertigung derartiger Leiterplatten nur im Rahmen einer stark durchrationalisierten Produktion hergestellt werden können.

Zu diesem Zweck werden bereits Koordinatenbohrmaschinen eingesetzt, die mit einer oder mehreren Bohrstationen entsprechend viele Werkstücke (Leiterplatten) gleichzeitig bearbeiten. In Abhängigkeit von der Standzeit eines einzelnen Bohrers und von den verschiedenen Bohrungsdurchmessern etc. müssen je nach vorgesehenem Arbeitsablauf die Bohrwerkzeuge ausgewechselt werden.

Häufig werden diese Koordinatenbohrmaschinen mit einem in einer Richtung, etwa der Y-Achse verschieblichen Werkstückschlitten (Leiterplatten-Spanntisch) versehen, der über geeignete Luftlager beispielsweise auf einer Sockelplatte extrem reibungsarm verschiebbar ist. Die Verschiebung in Richtung der X-Achse erfolgt mit Hilfe einer über diesem Tisch angeordneten balkenartigen Traverse, auf der wiederum über Luftlager ein in Querrichtung verschiebbarer Schlitten angeordnet ist. Dieser Schlitten trägt die häufig wie ein zylindrisches Bauteil ausgebildeten Bohrspindeleinheiten, die zur Erzeugung der Bohrtiefenverstellung in Z-Richtung entweder auf einem eigenen Schlitten (auf dem Querschlitten) angeordnet sind, oder selbst in Richtung der Z-Achse axial verschieblich angeordnet sind, z.B. mit Hilfe von geeigneten Luftlagern auf dem Querschlitten. Bei den hier eingesetzten Bohrspindeleinheiten handelt es sich um standardisierte, d.h. in verschiedenen Größen auf dem Markt erhältliche zylinderförmige Baugruppen, die den Antrieb und die Lagerung für die mit sehr hoher Drehzahl antreibbare eigentliche Bohrspindel mit der darin vorgesehenen Spannzange enthalten und somit eine nicht unerhebliche radiale Ausdehnung haben.

Da die auf dem Spanntisch angeordneten, zu bohrenden Leiterplatten bisweilen sehr groß sind und nur am Rand mit dem Spanntisch verbunden werden können, neigen sie dazu, sich zu verwerfen oder zu vibrieren etc., so daß die Leiterplatte im Interesse einer präzisen Bearbeitung während des Bohrens niedergehalten werden muß. Dies geschieht durch einen besonderen Niederhalter am bohrerseitigen Ende der Bohrspindeleinheit, gegenüber der dieser Niederhalter um ein gewisses Maß axial federnd verschieblich ist, etwa aufgrund der Wirkung eines Druckluftzylinders oder einer ähnlichen Vorrichtung. Der Niederhalter dient gleichzeitig als Saugdüse zum Entfernen der beim Bohren anfallenden Bohrspäne, ist mit entsprechend vielen Saugkanälen versehen und muß zur einwandfreien Fixierung der Leiterplatte und zur Beseitigung aller Bohrspäne ebenfalls eine angemessene radiale Ausdehnung haben.

Bei derartigen Koordinatenbohrmaschinen für die Herstellung von Leiterplatten sind bereits unterschiedliche Werkzeugwechselvcrrichtungen angegeben worden. So ist es beispielsweise bekannt, am stirnseitigen Ende des Spanntisches, quasi als Verlängerung desselben in Richtung auf die Bedienungsperson, ein gegebenenfalls auswechselbares Magazin mit nebeneinander aufgereihten Bohrwerkzeugen vorzusehen. Für einen Wechsel eines Bohrwerkzeuges wird dabei die Bohrspindel zunächst in eine Position oberhalb einer unbesetzten Werkzeugaufnahme im Magazin gefahren, wo dann das benutzte Werkzeug abgelegt wird. Danach fährt die Bohrspindel in eine Position axial oberhalb des sodann benötigten Bohrwerkzeuges, wobei eine besondere Mechanik im Inneren des Magazins eben dieses benötigte Bohrwerkzeug gegenüber den anderen, ebenfalls im Magazin befindlichen Bohrwerkzeugen in axialer Richtung nach oben heraushebt, um das Ergreifen dieses neuen Bohrwerkzeuges durch die Bohrspindel zu ermöglichen: Ohne ein solches axiales Herausheben des gewählten Bohrwerkzeuges wäre es nicht möglich, dieses Werkzeug durch die Spannzange der Bohrspindel zu ergreifen, weil der Niederhalter mit den anderen im Magazin sitzenden Bohrwerkzeugen zusammenstoßen würde - es sei denn, die Plätze im Magazin sind so weit auseinandergezogen, daß ein solcher Zusammenstoß nicht erfolgen kann, was aber dann bei vorgegebenen äußeren Abmessungen des Magazins nur zu einer sehr geringen Kapazität desselben führt. Im übrigen ist eine solche Mechanik zum Anheben des gewählten Bohrwerkzeuges konstruktiv aufwendig.

In einer anderen bekannten Ausführungsform einer Werkzeugwechselanordnung bei solchen LP-Koordinatenbohrmaschinen ist das Magazin auf dem auf der Traverse angeordneten Querschlitten vorgesehen, d.h. stets in unmittelbarer Nähe zu der zugehörigen Bohrspindeleinheit. Hierbei ist es möglich, ein Magazin nicht unerheblicher Kapazität vorzusehen, da der Abstand der einzelnen Magazinplätze nicht durch den Radius des Niederhalters oder der Bohrspindeleinheit bestimmt wird, doch ist auf jeden Fall ein besonderer Werkzeugwechselarm erforderlich, der das auszuwechselnde Bohrwerkzeug von der Bohrspindel bzw. der Spannzange entgegennimmt bzw. das ausgewählte neue Bohrwerkzeug vom Magazin an die Spannzange der Bohrspindel übergibt.

Bei einer ähnlichen bekannten Maschine (DE-OS 33 01 036) werden Magazine mit großer Kapazität verwendet, z.B. mit einer Kapazität von 100 Werkzeugen, welche Magazine ortsfest an einer Traverse befestigt sind, relativ zu der Arbeitseinheit vertikal verfahrbar sind. Am Werkstückträger ist mindestens ein Werkzeugübertrager angeordnet, der axial ausfahrbar ist und somit aus dem Magazin ein Werkzeug von unten entnehmen und dieses der Spindel zuführen kann, wobei der Bewegungsmechanismus des Tisches für die Bewegung des Werkzeugübertragers ausgenutzt wird. Die bekannte Maschine gestattet die Verwendung großer Magazine, in denen die Werkzeuge mit relativ geringem Abstand voneinander angeordnet sind, jedoch muß in Kauf genommen werden, daß der Werkzeugwechsel zeitaufwendig ist, da das Werkzeug zunächst vom Werkzeugübertrager aus der Spindel entnommen, danach zum Magazin gebracht und dort abgelegt werden muß und daß daran anschließend der Werkzeugübertrager ein neues Werkzeug aus dem Magazin entnehmen, dieses zur Spindel transportieren und an diese abgeben muß. Darüber hinaus muß auch der als Zwischenstation zwischen der Spindel und dem Magazin dienende Werkzeugübertrager mechanisch aufwendig ausgestaltet sein, weil er für das Entnehmen der Werkzeuge aus dem Magazin bzw. für das Einsetzen derselben in die Spindel axial ausfahrbar sein muß.

Die JP-A-61-164 746 vom 25.7.1986 gemäß "Patent Abstracts of Japan", M-544 vom 11.12.1986 zeigt eine Werkzeugwechselvorrichtung an einer Leiterplatten-Bohrmaschine, die einen besonderen Werkzeugwechselkopf zwischen der eigentlichen Bohrspindel und dem Werkzeugmagazin aufweist. Der hierfür erforderliche mechanische Aufwand ist besonders groß.

Ein älterer Vorschlag der Firma E. Lenz KG gemäß der nicht vorveröffentlichten DE-A1-35 39 662 vom 14.5.1987 sieht eine Leiterplatten-Bohrmaschine vor, bei der das Werkzeugmagazin am Werkstückträger befestigt ist. Im Werkzeugmagazin befinden sich mehrere Werkzeughalter in dichter Anordnung. Beim Ablegen oder Aufnehmen eines Werkzeuges übt ein zugleich als Niederhalter für das Werkstück dienendes Druckstück Druck auf benachbarte Werkzeughalter aus, die unter Überwindung von Federkräften in das Magazin eindrückbar sind. Dadurch ist es zwar möglich, auch bei dichter Anordnung vieler Werkzeuge diese direkt durch die Spindel abzulegen und aufzunehmen, wodurch ein rascher Werkzeugwechsel möglich ist, doch wird dieser Vorteil durch ein besonders aufwendiges Magazin erkauft, welches erhebliche Federwege für die eindrückbaren Werkzeughalter erfordert.

Allen voranstehend erläuterten Werkzeugwechselanordnungen bei Leiterplatten-Koordinatenbohrmaschinen ist gemeinsam, daß sie einen nicht unerheblichen konstruktiven Aufwand für mechanische Teile benötigen, die allein wegen des Werkzeugwechsels erforderlich sind. Hiernach ist es die der vorliegenden Erfindung zugrundeliegende Aufgabe, eine Leiterplatten-Koordinatenbohrmaschine mit mindestens einer Bohrspindeleinheit und einem damit zusammenwirkenden Niederhalter derart weiterzubilden, daß auch bei einer hohen Kapazität des zugeordneten Magazins kein besonderer mechanischer Aufwand allein wegen des Werkzeugwechsels notwendig ist.

Diese Aufgabe wird durch die Merkmale des Patentanspruches 1 gelöst. Durch die Aussparungen in dem Niederhalter wird es möglich, in konstruktiv besonders einfacher Weise ein zumindest vorläufiges Ergreifen des gewählten Bohrwerkzeuges durch die Spannzange der Bohrspindeleinheit zu erreichen. Dies geschieht also ohne zusätzliche bewegte Teile einer Werkzeugwechselanordnung wie im Stand der Technik und ohne ein besonders aufwendig konstruiertes und somit teueres Magazin wie beim älteren Vorschlag. Der auf einer kurzen Länge des Bohrerschaftes von der Spannzange nur vorläufig eingespannte Bohrer wird von der Bohrspindeleinheit aus dem Magazin herausgehoben und über eine vom Magazin separat angeordnete Spannstation eingefahren, in deren Nähe keine weiteren Bohrwerkzeuge magaziniert sind, mit denen das stirnseitige Ende des Gehäuses der Bohrspindeleinheit oder der dort angeordnete Niederhalter zusammenstoßen könnte. Indem die Bohrspindel mit dem Bohrer bis zu einem vorgegebenen Druck gegen diese Spannstation aufläuft, wird der vorläufig von der Spannzange erfaßte Bohrerschaft vollständig bis zu einem geeigneten Anschlag (etwa in Form eines Bundes auf dem Einspannschaft des Bohrers) in die Spannzange eingeschoben und somit endgültig in der Spannzange aufgenommen.

Die separat angeordnete Spannstation kann gleichzeitig als Längenmeßstation des neu in die Bohrspindel eingesetzten Bohrers verwendet werden, um beispielsweise bei genau auszuführenden Sacklochbohrungen auf die genaue Bohrlochtiefe schließen zu können. Dies wird erreicht, indem beispielsweise ein Sensor in Form eines induktiven Näherungsschalters oder eine Meßschranke mit dem Z-Achsenvorschub gekoppelt wird: Sobald die Spitze des fertig eingespannten Bohrers einen bestimmten Punkt erreicht hat oder die Meßschranke durchstößt, geht ein Signal an die Steuerung für die Bohrtiefenverstellung, so daß eine präzise Information darüber erhalten werden kann, wie lang jeweils der wirksame Teil des eingespannten Bohrers ist. Gleichzeitig kann ein derartiger Sensor kontrollieren, ob ein Bohrer abgebrochen ist, um in diesem Falle die Bearbeitung zu unterbrechen und z.B. ein Warnsignal abzugeben.

Wenn die im obigen Sinne als Sensor ausgebildete Spannstation in der Mitte zwischen zwei Werkzeugmagazinen angeordnet ist, kann der Austausch des einen Magazins gegen ein anderes mit neuen, z.B. geschärften Werkzeugen erfolgen, ohne daß sich eine Stillstandzeit für die Maschine ergibt.

Ein Ausführungsbeispiel der vorliegenden Erfindung wird unter Bezugnahme auf die beigefügten Figuren beschrieben.

Darin zeigt:

Fig. 1    eine Gesamt-Seitenansicht einer Koordinatenbohrmaschine nach der vorliegenden Erfindung;

Fig. 2    eine Vorderansicht der gleichen Koordinatenbohrmaschine, die mit nur einer Bohrspindel versehen ist;

Fig. 3    einen Teilausschnitt aus Fig. 2 in vergrößerter Darstellung, teilweise im Schnitt, und zwar im Augenblick des Einfahrens der Bohrspindeleinheit in die "Spannstation" der Werkzeugwechselvorrichtung.

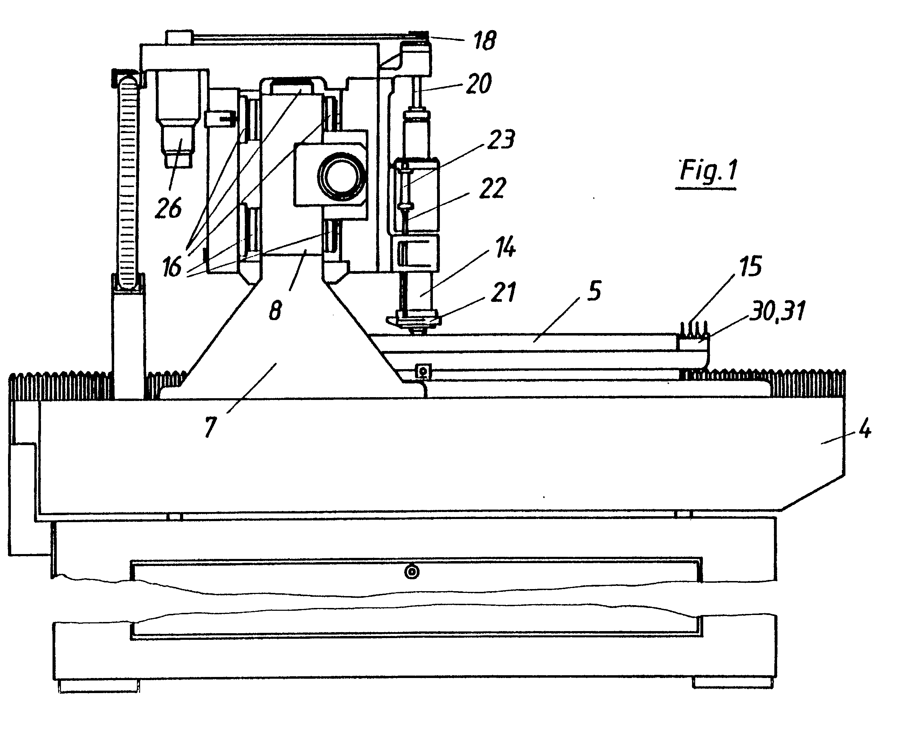

Eine Leiterplatten-Koordinatenbohrmaschine, wie sie in den Fig. 1 bis 3 dargestellt ist, gehört - allerdings ohne die neuartige Werkzeugwechselanordnung - zum Stand der Technik. Auf einem Grundgestell 2, welches die computergestützte elektrische Steuerung für die Koordinatenbohrmaschine enthalten kann, ist eine Grundplatte 4 vorgesehen, die das Bett für die in Richtung der Y-Achse verschiebliche Aufnahmeplatte/Werkstückspannplatte 5 darstellt, die über Luftlager 6 auf der Oberfläche der Granit-Grundplatte 4 abgestützt ist. Auf der Grundplatte 4 stützt sich im übrigen über entsprechende Seitenteile 7 auch noch eine brückenartige Traverse 8 für den Traversenschlitten 10 ab, der sich mit Hilfe des X-Achsenantriebes 12 quer zu der Verschiebungsrichtung der Aufnahmeplatte 5 verstellen läßt. Der Traversenschlitten 10 trägt eine Bohrspindeleinheit 14, d.h. den Antrieb und die Lagerung für die in die Bohrspindel 14 integrierte Spannzange (bei 24) zur Aufnahme der eigentlichen Bohrwerkzeuge 15. Der Traversenschlitten 10 ist wiederum über geeignete Axialluftlager 16 gegenüber der Traverse 8 extrem reibungsarm verschieblich. Die Bohrspindeleinheit 14 ist insgesamt in vertikaler Richtung, d.h. in Richtung der Z-Achse verstellbar, um die Bohrtiefenverstellung und andere, im Rahmen des Werkzeugwechsels notwendige Bewegungen durchzuführen. Die Bohrspindeleinheit 14 ist ein im Handel erhältliches fertiges Bauteil, das eine zylindrische Gestalt von nicht unerheblicher radialer Ausdehnung aufweist. Die Z-Achsenverstellung der Bohrspindeleinheit erfolgt über einen entsprechenden Antrieb 26, der über einen Riementrieb 18 eine Vorschubspindel 20 verdreht, die letztlich die Axialverstellung der Bohrspindeleinheit 14 bewirkt.

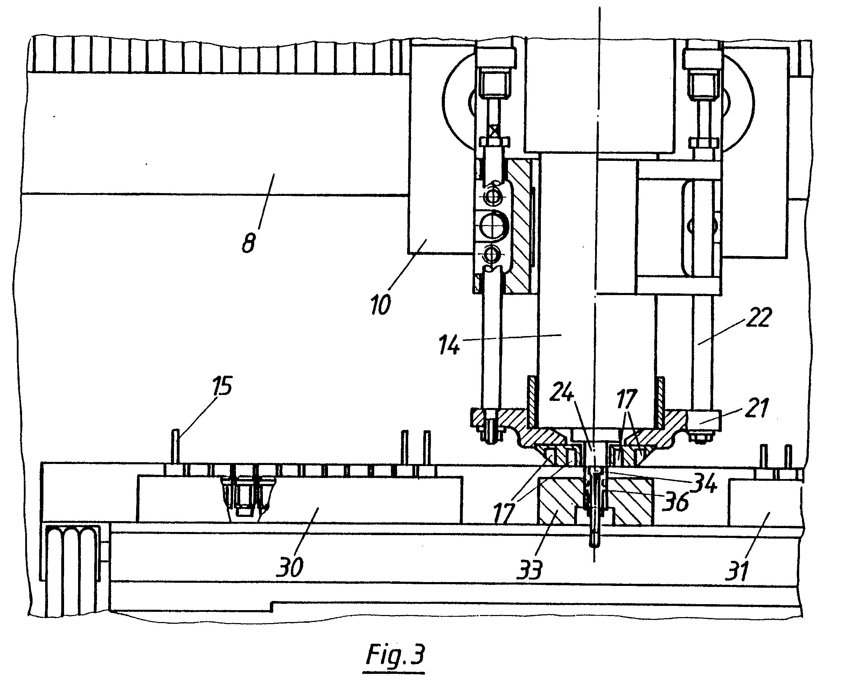

Aus Fig. 3 geht hervor, daß der der Bohrspindeleinheit 14 zugeordnete Niederhalter 21 von Führungsstangen 22 gehalten wird, die über Druckluftzylinder 23 mit der Bohrspindeleinheit 14 verbunden sind. Während des Bearbeitens von Leiterplatten ist der im Druckluftzylinder 23 enthaltene Kolben auf der oberen Seite mit Druckluft beaufschlagt derart, daß er sich in seiner unteren Totpunktlage befindet. Der Niederhalter befindet sich somit in einer (nicht dargestellten) Stellung unterhalb des fertig eingespannten Bohrwerkzeuges und legt sich zu Beginn der Zustellbewegung der Bohrspindeleinheit in Richtung auf die zu bohrende Leiterplatte an dieser an, um sie federnd nachgiebig niederzuhalten. Der Niederhalter, der koaxial zur Bohrspindeleinheit 14 zwischen dieser und der Werkstückspannplatte 5 angeordnet ist, dient also dazu, die bisweilen sehr großen Leiterplatten im Bereich der gerade durchgeführten Bohrung gegen die Aufnahmeplatte 5 zu drucken, damit sich die nur an ihren Rändern befestigbare Leiterplatte während des Bohrens nicht bewegt bzw. verzieht etc. Außerdem ist der Niederhalter 21 in bekannter Weise gleichzeitig als Saugdüse ausgebildet, um die beim Bohren entstehenden Bohrspäne zu entfernen. Die genaue Ausgestaltung des Niederhalters als Saugdüse ist zwar nicht dargestellt, ist aber einerseits Stand der Technik, andererseits auch für die Beurteilung der Erfindung nicht wesentlich. Für den Werkzeugwechselvorgang wird der Kolben in dem Druckzylinder 23 auf der unteren Seite mit Druckluft beaufschlagt, so daß der Niederhalter im Verhältnis zur Bohrspindeleinheit 14 nach aufwärts bewegt wird und sich von unten an deren Stirnfläche anlegt, wie dies in Fig. 3 dargestellt ist.

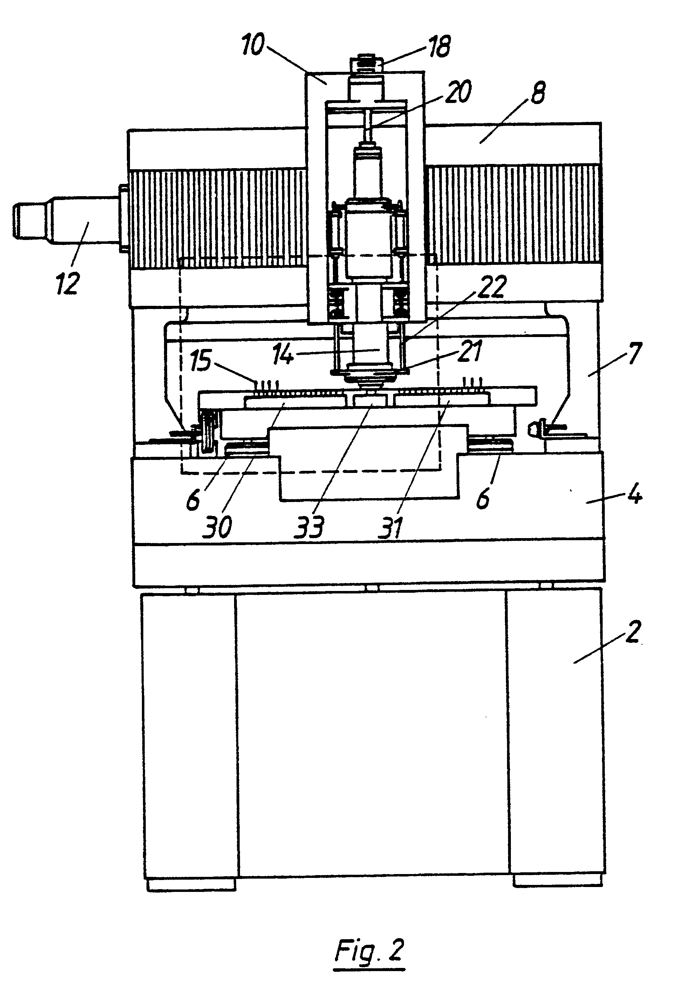

Am Rand der Aufnahmeplatte 5, d.h. im dargestellten Ausführungsbeispiel an dem der Bedienungsperson zugewandten stirnseitigen Ende in der Fig. 2 ist mindestens ein Werkzeugmagazin 30 vorgesehen, das beispielsweise in vier 12er Reihen insgesamt 48 Werkzeuge aufnimmt. Vorzugsweise kann mindestens ein weiteres Werkzeugmagazin 31 am vorderen Rand der Aufnahmeplatte 5 vorgesehen sein. Wie aus der Fig. 3 ersichtlich ist, ragen die in dem Magazin 30 bzw. 31 gespeicherten Bohrwerkzeuge15 mit ihrem Einspannschaft nach oben aus dem Magazin heraus, so daß die Bohrspindeleinheit 14 mit ihrer Spannzange (bei 24) bei einer entsprechenden Verstellung in X-bzw. Y-Richtung mit einem ausgewählten Werkzeug in einem der Magazine 30 oder 31 fluchtet und durch eine Zustellung in Z-Richtung das ausgewählte Werkzeug im Magazin vorläufig, d.h. am Anfang des Einspannschaftes ergreift und durch ein Zurückfahren in Z-Richtung aus dem Magazin heraushebt. Bei diesem Vorgang ist von entscheidender Wichtigkeit, daß der Niederhalter 21, wie dargestellt, an der den Werkzeugen 15 zugewandten Seite mit dem Werkzeugschaftdurchmesser entsprechenden Aussparungen 17 im Raster der Speicherplätze im Magazin versehen ist, damit die Bohrspindeleinheit 14 zusammen mit der Spannzange 24 überhaupt in die Lage versetzt wird, die Einspannschäfte der sehr dicht im Magazin 30 bzw. 31 gespeicherten Werkzeuge 15 zu ergreifen. Ohne derartige Aussparungen 17 im Niederhalter 21 wäre die gezeigte dichte Anordnung der Werkzeuge im Magazin nicht möglich, oder es müßten zusätzliche mechanische Mittel wie im Stand der Technik vorgesehen werden.

Nach dem Herausziehen des vorläufig ergriffenen, ausgewählten Werkzeuges aus dem Speicherplatz im Magazin wird die Bohrspindeleinheit 14 mit dem daran befindlichen, vorläufig gehalterten Werkzeug derart in X- und Y-Richtung verstellt, daß die Bohrspindel bzw. die Spannzange axial mit einer besonderen Spannstation 33 fluchtet, deren nähere Umgebung von Magazinplätzen freigehalten ist. Um den Einspannschaft des ausgewählten Werkzeuges, das zunächst nur an seinem obersten Ende vorläufig von der Spannzange festgehalten wird, vollends in die Spannzange 24 der Bohrspindeleinheit 14 einzudrücken, wird die Bohrspindeleinheit in Richtung auf die Spannstation 33 so vertikal verstellt, bis ein an jedem Bohrwerkzeug 15 vorgesehener Bund 34 von einer in Axialrichtung federnd gelagerten Hülse 36 in der Spannstation bis zur Anlage an der Spannzange 24 nach oben in diese hinein verschoben worden ist. Die Fig. 2 und 3 zeigen diesen Augenblick des Bewegungsablaufes der erfindungsgemäßen Werkzeugwechselanordnung.

Ein wesentlicher Teil der vorliegenden Erfindung besteht in den Aussparungen 17 in Form von beispielsweise Sacklöchern in der der Aufnahmeplatte 5 zugewandten Stirnfläche des Niederhalters 21. Diese Aussparungen 17 sind im Rastermaß der Speicherplätze im Magazin vorgesehen, so daß die aus den besetzten Speicherplätzen herausragenden Einspannschäfte der Bohrwerkzeuge 15 in diese Aussparungen einfahren können, um der Spannzange 24 zu ermöglichen, das ausgewählte Werkzeug bzw. den zugehörigen Einspannschaft beim Absenken der Bohrspindeleinheit/des Niederhalters auf die im Magazin sitzenden Werkzeuge zumindest vorläufig einzuspannen. Ohne eine solche Maßnahme in Form von den genannten Aussparungen 17 müßte das ausgewählte Werkzeug - wie im Stand der Technik üblich - durch eine geeignete Mechanik axial gegenüber den anderen Werkzeugen herausgehoben werden, damit der entsprechende Einspannschaft von der Spannzange ergriffen werden kann. Oder es wäre erforderlich, durch eine spezielle Werkzeugwechselvorrichtung das ausgewählte Werkzeug im Magazin zu ergreifen und in die Spannzange 24 einzuführen, wie dies ebenfalls im Stand der Technik praktiziert wird.

Die Bohrspindeleinheit 14 fährt also nach dem vorläufigen Ergreifen und Herausziehen des ausgewählten Werkzeuges aus dem Magazin 30 bzw. 31 über die Spannstation 33 ein, und indem die Bohrspindeleinheit 14 durch eine entsprechende Axialverstellung in Z-Richtung mit dem Bund 34 des ausgewählten Werkzeuges gegen eine federnd gelagerte Hülse 36 der Spannstation aufläuft, wird der vorläufig auf einem kurzen Stück ergriffene Einspannschaft des ausgewählten Werkzeuges vollends in die Spannzange 24 eingeschoben und dann endgültig für die Bearbeitung des Werkstükkes, d.h. der zu bohrenden Leiterplatte festgespannt.

Indem die Spannstation 33 als eine Art "Längenmeßstation" ausgebildet ist - etwa durch eine geeignete Lichtschranke oder durch induktive Mittel oder dergl. - kann sie gleichzeitig dazu dienen, die Länge des fertig eingespannten Bohrers festzustellen, was dadurch geschieht, daß bei fest eingespanntem Bohrer derjenige Zeitpunkt im Verhältnis zur Z-Achsenvorschubbewegung festgestellt wird, an dem die Spitze des eingespannten Bohrers eine bestimmte Marke durchläuft. Durch eine solche Ausgestaltung der Spannstation 33 kann erreicht werden, daß auch bei verschieden langen Bohrern in ihrer Tiefe genau vorgegebene Sacklöcher gebohrt werden können, selbst wenn die Bohrer bereits nachgeschliffen sind und somit von ihrer ursprünglich vorgegebenen Länge abweichen.

Als besonders vorteilhaft erweist sich, wenn zwei Magazine 30, 31 - etwa beiderseits der Spannstation 33 -vorgesehen sind. Dadurch wird es möglich, während der Maschinenarbeitszeit ein Magazin mit verbrauchten oder nicht mehr benötigten Werkzeugen gegen ein Magazin mit neuen Werkzeugen auszutauschen, ohne deswegen die Leiterplattenbohrmaschine anhalten zu müssen bzw. eventuelle Werkzeugwechsel nicht mehr durchführen zu können. Solche Werkzeugwechsel werden in erster Linie dadurch notwendig, daß ein bestimmter Bohrer seine Standzeit überschritten hat und nachgeschliffen werden muß. Darüber hinaus können natürlich auch Bohrerwechsel dadurch notwendig werden, daß unterschiedliche Bohrungsdurchmesser gebohrt werden müssen, oder daß ein Werkzeug im Zuge der Bearbeitung abgebrochen ist.

**Patentansprüche**

1. Werkzeugwechselanordnung an einer Leiterplatten-Koordinatenbohrmaschine, mit einer in einer Richtung verschieblichen Werkstückaufspannplatte (5) und mindestens einer darüber angeordneten, quer und vertikal dazu verschieblichen Bohrspindeleinheit (14), die verschiedene, in mindestens einem Magazin (30; 31) am Rande der Aufspannplatte (5) dicht nebeneinander abgespeicherte, mit einem Einspannschaft versehene Bohrwerkzeuge (15) in einer Spannvorrichtung (24) nacheinander aufnehmen kann, und mit einem zwischen der Spannplatte (5) und der Bohrspindeleinheit (14) angeordneten, relativ dazu axial verschieblichen, als Saugdüse für die Bohrspäne ausgebildeten Niederhalter (21) für die zu bearbeitende Leiterplatte während des Bohrens, wobei in dem Niederhalter (21) Aussparungen (17) im Rastermaß der Werkzeugspeicherplätze des Magazins (30; 31) vorgesehen sind, dadurch gekennzeichnet, daß in oder an dem mindestens einen Magazin (30; 31) keine für den Werkzeugwechsel zu aktivierenden mechanischen Teile vorgesehen sind und die Aussparungen (17) nur so tief sind, wie für ein sicheres Ergreifen des Einspannschaftes des ausgewählten Werkzeuges auf einem Teil seiner Länge durch die Bohrspindeleinheit ohne Berührung der anderen Einspannschäfte notwendig ist; und daß neben dem mindestens einen Magazin (30; 31) eine Spannstation (33) vorgesehen ist, die zum vollständigen Einschieben des Einspannschaftes des ausgewählten Werkzeuges (15) in die Spannvorrichtung (24) dient, und um die herum ein Bereich von Magazinplätzen freigehalten ist, der der Ausdehnung des Niederhalters (21) entspricht.

2. Werkzeugwechselanordnung nach Anspruch 1, dadurch gekennzeichnet, daß je ein Magazin (30; 31) beiderseits der Spannstation (33) angeordnet ist.

3. Werkzeugwechselanordnung nach Anspruch 1 oder 2, dadurch gekennzeichnet, daß das (die) Magazin(e) (30; 31) abnehmbar und gegen ein Magazin mit neu geschärften und/oder unterschiedlichen Bohrwerkzeugen (15) austauschbar ist (sind).

4. Werkzeugwechselanordnung nach einem der voranstehenden Ansprüche, dadurch gekennzeichnet, daß die Spannstation (33) als Längenmeßstation für das in der Spannvorrichtung (24) fertig eingespannte Bohrwerkzeug (15) ausgebildet ist.

5. Werkzeugwechselanordnung nach Anspruch 4, dadurch gekennzeichnet, daß die Längenmeßstation zur Kontrolle dient, ob ein Bohrer abgebrochen ist, um in diesem Falle die Bearbeitung zu unterbrechen und zum Beispiel ein Warnsignal abzugeben.

**Claims**

1. A tool changing arrangement on a printed circuit board coordinate boring machine, comprising a workpiece clamping plate (5) displaceable in one direction and at least one boring spindle unit (14), which is arranged above the workpiece clamping plate (5), is displaceable transversely and vertical relative to said plate and can receive different boring tools (15) in succession in a clamping device (24), which tools are stored closely adjacent one another in at least one magazine (30; 31) at the edge of the clamping plate (5) and are provided with a clamping shaft, and a holding-down device (21) for holding down the circuit board to be machined during the boring, which holding-down device is arranged between the clamping plate (5) and the boring spindle unit (14), is displaceable axially relative to said boring spindle unit and is designed as a suction nozzle for boring shavings, recesses (17) being provided in the holding-down device (21) and corresponding to the grid measurements of the tool storage spaces in the magazine (30; 31), characterised in that no parts which need to be activated mechanically for the tool change are provided in or on the at least one magazine (30; 31) and the recesse's (17) are only as deep as is necessary for a reliable grasping of the clamping shaft of the selected tool over part of its length by the boring spindle unit without touching the other clamping shafts, and in addition to the at least one magazine (30; 31), a clamping station (33) is provided, which is used for pushing the clamping shaft of the selected tool (15) fully into the clamping device (24), and around which an area of magazine spaces is kept free corresponding to the extension of the holding-down device (21).

2. A tool changing arrangement according to claim 1, characterised in that a magazine (30; 31) is arranged on each side of the clamping station (33).

3. A tool changing arrangement according to claim 1 or 2, characterised in that the magazine(s) (30; 31) can be removed and replaced by a magazine with newly sharpened and/or different boring tools (15).

4. A tool changing arrangement according to one of the preceding claims, characterised in that the clamping station (33) is designed as a length measuring station for the boring tool (15) fully clamped in the camping device (24).

5. A tool changing arrangement according to claim 4, characterised in that the length measuring station is used for monitoring whether a boring tool has broken, in order in this case to interrupt the machining and to transmit a warning signal, for example.

**Revendications**

1. Dispositif de changement d'outils pour une machine à percer les cartes imprimées fonctionnant en coordonnées, avec un plateau de fixation des pièces (5) déplaçable dans une direction et au moins une unité de broche de perçage (14) disposée au-dessus et pouvant se déplacer transversalement et verticalement, qui peut prendre successivement différents outils de perçage (15) dotés d'une tige de serrage et stockés en étant étroitement juxtaposés dans au moins un magasin (30 ; 31) placé sur le bord du plateau de fixation (5) et avec un presse-tôle (21) ayant la forme d'une buse d'aspiration pour les copeaux de perçage disposé entre le plateau de fixation (5) et l'unité de broche de perçage (14) et pouvant se déplacer relativement à ceux-ci dans la direction axiale, afin de maintenir la carte imprimée en place pendant l'usinage, ce presse-tôle (21) présentant des évidements (17) correspondant à la trame des emplacements de rangement des outils dans le magasin (30 ; 31), caractérisé en ce que le magasin au moins unique (30 ; 31) ne possède pas de pièces mécaniques qui doivent être activées pour le changement d'outils et en ce que ces évidements (17) sont juste assez profonds pour permettre une saisie sûre de la tige de serrage de l'outil de perçage sélectionné sur une partie de sa longueur par l'unité de broche de perçage, sans qu'il y ait nécessairement contact avec les autres tiges de serrage, et en ce qu'il est prévu à côté du magasin au moins unique (30 ; 31) une station de serrage (33) qui sert à l'introduction complète de la tige de serrage de l'outil sélectionné (15) dans le dispositif de serrage (24) et autour de laquelle est gardée vide d'emplacement de stockage une zone correspondant à l'extension du presse-tôle (21).

2. Dispositif de changement d'outils selon la revendication 1, caractérisé en ce qu'un magasin (30 ; 31) est disposé de part et d'autre de la station de serrage (33).

3. Dispositif de changement d'outils selon la revendication 1 ou 2, caractérise en ce que le ou les magasins (30 ; 31) sont amovibles et peuvent être remplacés par un magasin comportant des outils de perçage (15) neufs ou réaffûtés.

4. Dispositif de changement d'outils selon l'une des revendications précédentes, caractérisé en ce que la station de serrage (33) prend la forme d'une station de mesure de la longueur de l'outil de perçage (15) fixé définitivement dans le dispositif de serrage (24).

5. Dispositif de changement d'outils selon la revendication 4, caractérisé en ce que la station de mesure de la longueur sert à déterminer si un foret est brisé, afin dans ce cas d'interrompre l'usinage et de fournir par exemple un signal d'avertissement.

Fig.1

EP 0 287 071 B1

Fig. 2

*Fig.3*

EP 0 287 071 B1